# DEMANDE DE BREVET EUROPEEN

(11) **EP 4 389 793 A1**
(43) Date de publication de la demande: **26.06.2024**
(21) Numéro de dépôt: 23218236.0
(22) Date de dépôt: 19.12.2023
(51) Int. Cl.: C08G 18/10, B33Y 70/00, C08G 18/12, C08G 18/16, C08G 18/67, C08G 18/72, C08G 18/73, C08G 18/75, C08L 75/14, C08L 75/16, C09D 175/14, C09D 175/16, G03F 7/00

(54) **RÉSINE DE POLYURÉTHANE PHOTORÉTICULABLE**

(30) Priorité: 19.12.2022 FR 2213780
(71) Demandeur: COMMISSARIAT À L'ÉNERGIE ATOMIQUE ET AUX ÉNERGIES ALTERNATIVES, 75015 Paris (FR)
(72) Inventeur: ROLERE, Sébastien, 38054 Grenoble cedex 09 (FR); FLASSAYER, Cécile, 38054 Grenoble cedex 9 (FR)
(74) Mandataire: Germain Maureau

(57) **Abrégé**

Résine photoréticulable adaptée à l'impression par stéréolithographie pour former un polyuréthane photoréticulé (D), la résine photoréticulable comprenant :
- un oligomère uréthane photoréticulable (B),
- une formulation (C) comprenant au moins un polyol fonctionnalisé par des groupements photoréticulables, et
- un photoamorceur.

## Description

La présente invention concerne le domaine des matériaux polyuréthane et notamment des matériaux en polyuréthane photoréticulable imprimable par des procédés d'impression 3D dont la stéréolithographie.

Les résines de polyuréthanes thermodurcissables sont largement utilisées dans la fabrication de nombreux produits de consommation courante ou à usage industriel. Ils sont de très bons isolants thermiques et présentent d'excellentes propriétés mécaniques. Afin d'élargir leur champ d'application, des résines de polyuréthane photoréticulable ont vu le jour. Grâce à leurs propriétés photosensibles, ces matériaux peuvent être mis en oeuvre par impression 3D, ce qui permet de réaliser des prototypages rapides mais également de fabriquer des produits de consommation courante avec une grande définition. Toutefois, il n'existe pas à ce jour de résines polyuréthane photoréticulables permettant de retrouver les propriétés mécaniques des polyuréthanes thermodurcis classiquement obtenus par moulage.

Le document EP1503242 décrit des exemples de résine à base d'oligomère uréthane-acrylate, de monomère d'acrylate et de modificateur de polymérisation pour une impression par stéréolithographie. Cette résine conduit à des solides de propriétés thermiques et mécaniques variables (de très souples à très rigides) selon les précurseurs utilisés. Toutefois, même en variant les concentrations relatives des différents composants, ou d'additifs, il est difficile de retrouver les propriétés des polyuréthanes thermodurcis de référence. Les matériaux obtenus sont sensibles à l'hydrolyse et leurs propriétés se rapprochent davantage de celles des résines acrylates que celle des polyuréthanes thermodurcissables de référence.

Un des buts de la présente invention est de pallier au moins l'un des inconvénients précités. A cet effet, la présente invention propose une résine photoréticulable adaptée à l'impression par stéréolithographie, telle que la technologie Digital Light Processing (DLP), pour former un polyuréthane photoréticulé D, la résine photoréticulable comprenant :
- un oligomère uréthane photoréticulable B,
- une formulation C comprenant au moins un polyol fonctionnalisé par des groupements photoréticulables, et
- un photoamorceur, par exemple du TPO (oxyde de phosphine).

Ainsi, la résine de l'invention comprend des réactifs qui, lorsqu'ils sont placés en condition de réagir, permettent une photopolymérisation par exposition à un rayonnement actinide - typiquement un rayonnement visible ou UV, et conduisent à un polyuréthane photoréticulé D. Comme on le verra par la suite, le polyuréthane photoréticulé D obtenu présente des propriétés similaires à celles obtenues par le polyuréthane thermodurci lorsque les précurseurs présents dans la formulation mère de la résine dudit polyuréthane thermodurcissable sont également utilisés pour former l'oligomère uréthane photoréticulable B et la formulation C d'au moins un polyol fonctionnalisé.

Il est à noter que la résine photoréticulable selon l'invention est dépourvue de monomère d'acrylate.

La terminologie anglo-saxonne de la technologie 'Digital Light Processing' peut se traduire en français par 'Traitement numérique de la lumière'.

Selon une autre disposition, la résine photoréticulable de l'invention est dépourvue de diluant réactif.

Selon une disposition, la résine photoréticulable est apte à former un polyuréthane photoréticulé D uniquement par photopolymérisation.

Les polyols fonctionnalisés de la formulation C ne réagissent pas avec l'oligomère d'uréthane photoréticulable B, l'obtention d'un polyuréthane photoréticulé D est uniquement obtenu par photoréticulation de la résine photoréticulable.

Selon une disposition, l'oligomère d'uréthane photoréticulable B est dépourvu de groupement isocyanate.

La formulation C comprend au moins un polyol fonctionnalisé par des groupements photoréticulables. Autrement dit, la formulation C comprend au moins un composé qui contenait des hydroxyles, les hydroxyles ayant été fonctionnalisés au préalable.

Selon un mode de réalisation particulier, la résine photoréticulable adaptée à des impressions par stéréolithographie pour former un polyuréthane photoréticulé D, est constituée de :
- un oligomère uréthane photoréticulable B,
- une formulation C constituée d'un polyol fonctionnalisé par des groupements photoréticulables, et
- un photoamorceur.

De manière concrète, dans la résine photoréticulable :
- la proportion d'oligomère uréthane photoréticulable B peut être comprise dans une plage allant d'une valeur de 50% en poids à une valeur strictement inférieure à 100% en poids,
- la proportion de la formulation C peut être comprise dans une plage allant d'une valeur strictement supérieure à 0% en poids à une valeur de 50% en poids,
- la proportion de photoamorceur peut être comprise dans une plage allant de 0,1% en poids à 5% en poids, et
les proportions d'oligomère uréthane photoréticulable B, de la formulation C et de photoamorceur étant choisies de sorte que la résine photoréticulable présente une viscosité inférieure ou égale à 3 Pa.s à 25°C et 100 Hz. Cette valeur de viscosité est de préférence stable sur 72 heures. Lesdites proportions constituent au total 100% en poids de la résine photoréticulable.Selon une possibilité, la résine photoréticulable comprend en outre un matériau antioxydant dans une proportion allant de 0% en poids à 2% en poids, et/ou un agent azurant dans une proportion allant de 0% en poids à 2% en poids, et/ou un absorbeur UV dans une proportion allant de 0% en poids à 2% en poids, et/ou un stabilisant UV dans une proportion allant de 0% en poids à 2% en poids, et/ou un agent dégazant dans une proportion allant de 0% en poids à 2% en poids.

Selon un mode de réalisation, la résine photoréticulable adaptée à des impressions par stéréolithographie pour former un polyuréthane photoréticulé D, est constituée de :
- un oligomère d'uréthane photoréticulable B,
- une formulation C constituée d'un (ou plusieurs) polyol(s) fonctionnalisé(s) par des groupements photoréticulables,
- un photoamorceur, et
- un matériau antioxydant et /ou
- un agent azurant et /ou
- un absorbeur UV et /ou
- un stabilisant UV et /ou
- un agent dégazant.

Selon une disposition, l'au moins un polyol fonctionnalisé de la formulation C est obtenu par la réaction d'un premier agent de couplage photoréticulable, tel qu'un composé acrylate ou un méthacrylate, par exemple du MCOC (Chlorure de méthacryloyle), avec au moins un premier polyol, par exemple du VORANOL^{™}CP300. Le composé VORANOL^{™}CP300, notamment disponible auprès de la société Dow^{®}, désigne le trialcool 'Glycérol éthoxylate-*co-*propoxylate triol'.

Selon une variante, la formulation C comporte un deuxième polyol fonctionnalisé, obtenu par la réaction d'un deuxième agent de couplage photoréticulable, tel qu'un composé acrylate, avec au moins un deuxième polyol par exemple du TMP (Acronyme de triméthylolpropane disponible auprès de BASF^{®}.

Il est à noter que les premier et deuxième polyols cités sont avantageusement choisis parmi les réactifs de la formulation mère de la polyuréthane thermodurcissable conduisant à la résine PRC1819^{®} disponible auprès de la société Synthene^{®}.

Le premier et /ou le deuxième agent de couplage permettant la fonctionalisation du premier et/ou du deuxième polyol est présent dans des conditions stoechiométriques vis-à-vis des fonctions alcools.

Le premier agent de couplage et le deuxième agent de couplage peuvent être identiques.

Selon une disposition, l'oligomère uréthane photoréticulable B est obtenu par réaction entre un oligomère uréthane A comprenant des fonctions isocyanates libres et un troisième agent de couplage photoréticulable, tel qu'un composant comprenant un groupement photoréticulable, par exemple un groupement acrylate, et un groupement réactif vis-à-vis des isocyanates, par exemple un groupement hydroxyle.

Selon une possibilité, le troisième agent de couplage photoréticulable est du HEMA (HydroxyEthylMéthAcrylate) disponible chez Sigma Aldrich^{®}.

Selon une disposition, le rapport molaire entre les fonctions isocyanates et les groupements réactifs vis-à-vis des isocyanates du troisième agent de couplage est compris dans une plage allant de 1 à 2,5 et notamment dans une plage allant de 1 à 2. Le troisième agent de couplage photoréticulable peut être considéré comme un diluant réactif permettant d'augmenter la conversion des isocyanates en l'oligomère uréthane A. En effet, le couplage conduit à un mélange qui devient de plus en plus visqueux avec l'avancement de la réaction (formation de l'oligomère uréthane photoréticulable B). Ainsi, la présence d'un troisième agent de couplage permet de greffer un groupement photoréticulable et également d'améliorer la viscosité du mélange réactionnel de sorte à favoriser la mobilité des molécules et l'avancement de la réaction. A la fin de la réaction, tous les isocyanates de A ont réagi avec les groupements réactifs vis-à-vis des isocyanates, de sorte l'oligomère uréthane photoréticulable B ne présente aucun groupe isocyanate.

Pour autant, il faut noter que le troisième agent de couplage est présent dans une quantité inférieure à celle d'un diluant réactif. Selon un exemple de réalisation particulier, l'excès d'HEMA (50%) ne représente qu'environ 17,5% m de l'oligomère uréthane photoréticulable B et environ 11,5% m du polyuréthane photoréticulé D.

Selon une possibilité, lorsque des quantités stœchiométriques sont utilisées en HEMA, la viscosité est de 700 Pa.s (25°C et fréquence d'un hertz). En présence d'un excès de 40% en HEMA, la viscosité est de 10 Pa.s (mêmes conditions de mesure).

Selon une disposition, l'excès en HEMA de 20% conduit à une viscosité comprise entre 90-100 Pa.s (25°C et fréquence d'un hertz).

Selon une disposition, le procédé d'obtention de l'oligomère uréthane photoréticulable B est réalisé à 65°C pendant 6h.

De manière concrète, l'oligomère uréthane A est obtenu par réaction d'un polyisocyanate, par exemple du MDI (acronyme anglo-saxon de Methylene Diphenyl dilsocyanate), TDI (diisocyanate de toluène), H12MDI (4,4'-dicyclohexylmethane diisocyanate ou MDI hydrogéné), HDI (Hexamethylene Diisocyanate) ou du SL000221^{®} (par exemple de chez Synthene^{®}), synthétisé à partir de H12MDI, de HDI et de polyols, avec au moins un troisième polyol, en présence d'un catalyseur de réaction alcool/isocyanate, le rapport molaire entre les fonctions alcools et les fonctions isocyanates est strictement inférieur à 1 de sorte que la réaction reste incomplète et que l'oligomère uréthane A conserve des fonctions isocyanates libres résiduelles.

Selon une possibilité, le procédé d'obtention de l'oligomère uréthane A est réalisé à 90°C pendant 2h sous une pression de 200 mbars.

Les deux réactifs sont également présents dans la formulation mère conduisant à un polyuréthane thermodurcissable utilisant le Capa^{®}4101 (tetrafunctional polyol terminated with primary hydroxyl groups) notamment disponible auprès de la société SpecialChem^{®}. En conséquence, la résine photoréticulable selon l'invention pourra conduire à un polyuréthane photoréticulé D dont la structure chimique est très proche de celle du polyuréthane thermodurci obtenu à partir du Capa^{®}4101. L'obtention des deux résines de polyuréthane est certes effectuée par des voies de synthèses différentes mais les polyuréthanes résultant présentent des propriétés mécaniques similaires comme on pourra le voir ultérieurement dans tableau 2 ci-dessous.

Il est ainsi possible d'appliquer l'invention à des réactifs commerciaux prévus pour la fabrication d'un polyuréthane thermodurci bien connu pour obtenir une formulation d'un matériau photoréticulable conduisant à un solide aux propriétés similaires à celles dudit polyuréthane thermodurci.

Selon une possibilité, l'oligomère uréthane A est obtenu à partir d'un mélange constitué de polyisocyanate dans une plage allant de 90% en poids à 100% en poids et du troisième polyol dans une plage allant d'un valeur non nulle à une valeur de 10% en poids et de catalyseur dans une plage allant d'une valeur non nulle à une valeur de 0,5% en poids, notamment du EGECat^{®} 8-S de Ege Kimya^{®}, de sorte à obtenir un oligomère uréthane A d'une viscosité inférieure à 10 Pa.s à 25°C sur la gamme 0,1-100 Hz. La quantité du troisième polyol est également déterminée par la viscosité du polyisocyanate initial.

Selon d'autres caractéristiques, la résine photoréticulable selon l'invention comporte une ou plusieurs des caractéristiques optionnelles suivantes considérées seules ou en combinaison :
Le premier polyol, le deuxième polyol et/ou le troisième polyol sont de natures différentes.

Le premier polyol, le deuxième polyol et/ou le troisième polyol sont de natures identiques.

Les polyols parmi les polyols fonctionnalisés par des groupements photoréticulables, le premier polyol, le deuxième polyol et le troisième polyol sont tous liquides à température ambiante.Le premier agent de couplage, le deuxième agent de couplage et/ou le troisième agent de couplage sont identiques.

Le premier agent de couplage, le deuxième agent de couplage et/ou le troisième agent de couplage sont différents.

La résine photoréticulable adaptée à des impressions par stéréolithographie pour former un polyuréthane photoréticulé D, est constituée de :
- un oligomère d'uréthane photoréticulable B,
- une formulation C constituée d'un polyol fonctionnalisé par des groupements photoréticulables et d'un deuxième polyol fonctionnalisé par des groupements photoréticulables,et
- un photoamorceur.

Le procédé d'obtention de l'oligomère A comprend la mise en présence du polyisocyanate, du troisième polyol et du catalyseur, tels que précédemment décrits, et l'application d'un traitement thermique à une température comprise entre 80°C et 100°C, notamment environ 90° C pendant environ 2 heures. Ledit procédé est réalisé sous une pression de 200 mbars.

Le procédé d'obtention de l'oligomère C de polyol fonctionnalisé comprend l'application d'une température inférieure à 100°C, une pression inférieure ou égale à la pression atmosphérique. L'atmosphère du milieu réactionnel peut être une atmosphère inerte ou de l'air. Le procédé d'obtention de polyuréthane photoréticulé D comprend les étape de :
- fournir la résine photoréticulable telle que précédemment décrite et,
- imprimer par stéréolithographie en applicant au moins un rayonnement actinide sur la résine de polyuréthane photoréticulable à sa fréquence de photoréticulation.

Selon une disposition, la résine de polyuréthane photoréticulable conduit au polyuréthane photoréticulé D uniquement par photoréticulation.

Les polyols fonctionnalisés de la formulation C ne réagissent pas avec l'oligomère d'uréthane photoréticulable B.

L'obtention d'un polyuréthane photoréticulé D à partir de la résine photoréticulable est uniquement obtenu par photoréticulation.

La stéréolithographie est réalisée par DLP (acronyme anglosaxon de Digital light processing).

D'autres caractéristiques, buts et avantages apparaitront à la lecture de la description détaillée ci-après, d'un exemple de mise en oeuvre non limitatif, faite en référence aux figures annexées dans lesquelles :
[Fig.1] représente une vue schématique d'une réaction de polymérisation d'une formulation mère commerciale conduisant à un polyuréthane thermodurci de référence.
[Fig.2] représente une vue schématique de réactions de fabrication d'un oligomère uréthane A et d'un oligomère d'uréthane photoréticulable B.
[Fig.3] représente une vue schématique de la réaction de fabrication d'un oligomère C polyol photoréticulable à partir d'un troisième polyol et d'un troisième agent de couplage photoréticulable.
[Fig.4] représente une vue schématique de fabrication d'un polyuréthane photoréticulé D à partir de l'oligomère d'uréthane photoréticulable B et de l'oligomère C polyol photoréticulable en présence d'au moins un photoamorceur et d'irradiation actinide.
[Fig.5] représente un graphique de la viscosité en cisaillement en fonction du temps à différentes fréquences.
[Fig.6] représente des photos de barreaux normés formés en polyuréthane photoréticulé D par stéréolithographie.

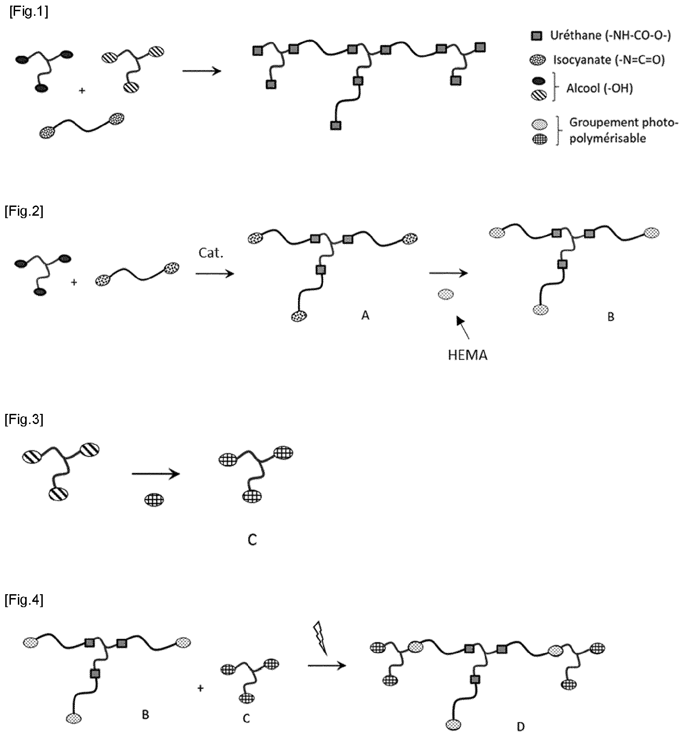

La figure 1 illustre la synthèse d'un composé polyuréthane thermodurci de référence, la résine PRC1819^{®} de Synthene^{®}, dont l'invention vise à reproduire les propriétés mécaniques avantageuses bien connues par l'homme de l'art. La synthèse est réalisée à partir d'une formulation mère commerciale comprenant un composé polyisocyanate SL000221^{®}, et une combinaison des trois polyols suivant : le VORANOIL^{™}CP300 (Dow^{®}), le triméthylolpropane et le CAPA^{®}4101). Ces réactifs sont mélangés et soumis à un traitement thermique de durcissement conduisant à une réticulation et à l'obtention du PRC1819^{®}.

La figure 2 illustre maintenant une première étape permettant la réalisation de la résine selon l'invention dans laquelle ledit composé isocyanate SL000221^{®} issu de ladite formulation mère commerciale est mélangé avec l'un desdits trois polyols, présent en défaut (96% en poids d'isocyanate SL000221^{®} et 3,70% en poids du polyol CAPA^{®}4101), et un catalyseur EGECat^{®} 8-S environ 0.90% en poids du mélange, de sorte à obtenir un oligomère uréthane A (figure 2). Le rapport molaire largement favorable aux fonctions isocyanates dans le mélange réactionnel permettent d'obtenir l'oligomère uréthane A riche de fonctions isocyanates libres.

Puis, toujours illustré sur la figure 2, l'oligomère uréthane A est mis en présence d'un troisième agent de couplage photoréticulable, par exemple un agent comprenant une fonction (meth)acrylate pour sa propriété photoréticulable et une fonction hydroxy pour sa réactivité avec la fonction isocyanate, notamment de l'HEMA, pour former l'oligomère uréthane B. Les réactifs sont mis en présence selon des quantités stœchiométriques (par exemple une proportion d'environ 47 % en oligomère uréthane A et environ 53% en poids en HEMA). Selon une autre possibilité, le rapport molaire entre les fonctions isocyanates et hydroxyles sont comprises entre 1,1 et 2.5 de sorte à diminuer la viscosité de l'oligomère uréthane A auquel cas le troisième agent de couplage photoréticulable sert de diluant et de réactif.

Selon une autre étape de réalisation de la résine selon l'invention, illustrée à la figure 3, la formulation C est fabriquée par réaction entre le premier polyol VORANOL^{™}CP300, issu de la formulation mère commerciale, et un premier agent de couplage photoréticulable tel qu'un dérivé de (meth) acrylate et comprenant une fonction capable de réagir avec les hydroxyles du polyol, notamment du MCOC (acronyme anglosaxon pour chlorure de méthacryloyle disponible auprès de la société Sigma Aldrich^{®}), de sorte à obtenir un polyol fonctionnalisé et photoréticulable. Selon une variante non illustrée, la formulation C comprend également un deuxième polyol fonctionnalisé obtenu par réaction entre un deuxième polyol, tel que du TMP (triméthylolpropane) issu de la formulation mère commerciale et un deuxième agent de couplage pouvant être identique au premier agent de couplage MCOC (les proportions massiques sont indiquées dans le tableau 1 ci-dessous). Selon encore d'autres variantes non illustrées, le MCOC ou agent de couplage/ de fonctionnalisation du premier et deuxième polyol est remplacé par du 2-isocyanatoethyl méthacrylate, le glycidyl méthacrylate, ou l'anhydride méthacrylique.

Les conditions de synthèse comprennent une température inférieure à 100°C, une pression inférieure ou égale à la pression atmosphérique, sous atmosphère inerte ou à l'air. Un ajustement du pH du mélange réactionnel peut être nécessaire pour atteindre un PH d'environ 1 ainsi qu'un post traitement de purification.

Enfin, la résine de polyuréthane photoréticulable est obtenue par la combinaison de l'oligomère uréthane B (environ 66% en poids), du polyol fonctionnalisé par des groupements photoréticulables (environ 32% en poids), un photoamorceur, tel que le TPO (l'oxyde de phosphine diphényl(2,4,6-trimethylbenzoyle - environ 1% en poids) et quelques éventuels additifs listés au tableau 1.

**[Table 1]**

| **Mélange** | **Produit** | **Proportion (%m)** |
|---|---|---|
| **Produit A** | SL000221^{®} | 96,0 |
| | EGE^{®}Cat 8-S | 0,297 |
| | CAPA^{®}4101 | 3,69 |
| **Produit B** | **Produit A** | 47,2 |
| | HEMA (150%) | 52,8 |
| **Produit C** | TMP | 2,19 |
| | VORANOL^{™}CP300 | 45,2 |
| | MCOC | 52,6 |
| **Produit D** | **Produit C** | 32,0 |
| | Irganox^{®} 1010 | 0,114 |
| | Uvitex^{®} 0B | 0,049 |
| | Tinuvin^{®} 312 | 0,098 |
| | Tinuvin^{®} 765 | 0,098 |
| | WorléeAdd^{®} 602 | 0,130 |
| | TPO | 1,00 |
| | **Produit B** | 66,5 |

**Tableau 1 : Composition de la formulation 1 de polyuréthane photoréticulable et imprimable :**
Produit A : Oligomère uréthane avancé à viscosité contrôlée
Produit B : Oligomère uréthane photoréticulable (fonction méthacrylate), contenant un excès de 50% d'HEMA (Hydroxyéthylméthacrylate)
Produit C : Formulation comprenant au moins un polyol fonctionnalisé avec du MCOC (chlorure de méthacryloyle)
Cette résine permet sous l'effet d'un rayonnement actinide, l'obtention d'un polyuréthane photoréticulé D présentant une structure chimique et des propriétés mécaniques similaires à celles du polyuréthane thermordurci PRC1819^{®} obtenu à partir de la formulation mère commerciale comme indiqué au tableau 2 ci-dessous.

Précisons que l'Irganox^{®} 1010 est un anti-oxydant disponible par exemple auprès de BASF^{®}, le Uvitex^{®} 0B est un agent azurant optique disponible par exemple auprès de ChemBK^{®}, le Tinuvin^{®} 312 est un absorbant UV disponible auprès de BASF^{®},le Tinuvin^{®} 765 est un stabilisant UV disponible auprès de BASF^{®},le WorléeAdd^{®} 602 est un agent dégazant disponible auprès de Specialchem^{®}.

### Résultats expérimentaux

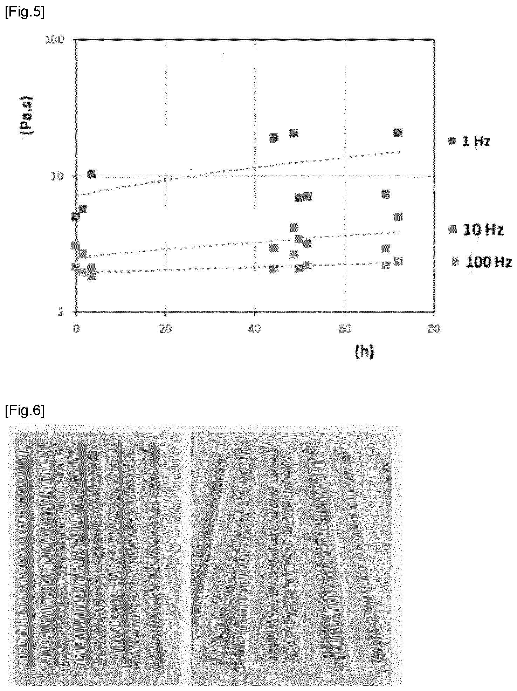

La viscosité de la résine photoréticulable selon l'invention est rapportée sur la figure 5 illustrant des valeurs de viscosité de cisaillement (Pa.s) en fonction du temps de vie (heure) de la formulation à une fréquence de sollicitation de 1 Hz, 10 Hz et 100 Hz pouvant correspondre au cisaillement appliqué par la racle lors de l'impression. Comme il est visible sur la figure 5, la viscosité est stable jusqu'à au moins 72h. Ainsi, la résine n'évolue pas chimiquement durant ce laps de temps, et peut être utilisée à minima pendant 72h en fabrication additive.

La figure 6 représente des photos illustrant des éprouvettes normalisées en polyuréthane photoréticulé D transparent, obtenues par impression DLP à partir de la formulation de la présente invention décrite ci-dessus. Il n'y a pas de différence à l'œil entre les éprouvettes de polyuréthane photoréticulé D et celles de polyuréthane themordurci (non illustrés). Ainsi, la résine de l'invention peut être utilisée pour imprimer des objets sans défaut apparent (pas de bulles par exemple), transparents, comme dans le cas de résine PU thermodurcissable.

Le tableau 2 ci-dessous illustre les propriétés mécaniques des éprouvettes en polyuréthane photoréticulé D obtenu selon l'invention et celles obtenue à partir du polyuréthane thermodurci selon la formulation mère commerciale.

**[Table 2]**

| **Propriétés** | **Résine PU thermodurcissable de référence (PRC1819^{®})** | **Résine PU imprimable par DLP (Invention)** |
|---|---|---|
| *Normes associées* | | |
| **Aspect** | Transparent | Transparent |
| **Couleur** | Incolore | Légèrement jaune |
| **Dureté (Shore D)** | 85 | 86 |
| *ISO868:2003 Shore D1* | | |
| **Module de flexion (MPa)** | 2200 | 2200 ± 90 |
| *ISO178:2011* ; 2 mm/min | | |
| **Contrainte maximale en flexion (MPa)** | 80 | 92,5 ± 0,5 |
| *ISO178:2011* ; 2 mm/min | | |
| **Température de flexion sous charge (°C)** | 86 | 96 |
| *ISO75-2:2013* ; Méthode B (0,45 MPa) | | |

**Tableau 2 : Comparaison des propriétés optiques, mécaniques et thermiques du polyuréthane photoréticulé D imprimé par DLP et développé selon l'invention, avec celles du polyuréthane thermodurci de référence :**
Comme illustré dans ce tableau comparatif, les valeurs concernant le polyuréthane photoréticulé D sont très proches de celles obtenues avec le polyuréthane thermodurci.

Ainsi, la présente invention propose une résine photoréticulable pour des impressions par stéréolithographie, ainsi qu'un procédé d'obtention de polyuréthane photoréticulé D présentant des propriétés mécaniques similaires à celles obtenues avec du polyuréthane thermodurci à partir des mêmes précurseurs principaux. L'invention est également transposable à toutes les formulations mères commerciales destinées à former des polyuréthanes thermodurcissables.

Il va de soi que l'invention n'est pas limitée aux variantes de réalisation décrites ci-dessus à titre d'exemple mais qu'elle comprend tous les équivalents techniques et les variantes des moyens décrits ainsi que leurs combinaisons.

## Revendications

1. Résine photoréticulable adaptée à l'impression par stéréolithographie pour former un polyuréthane photoréticulé (D), la résine photoréticulable comprenant :
- un oligomère uréthane photoréticulable (B),
- une formulation (C) comprenant au moins un polyol fonctionnalisé par des groupements photoréticulables, et
- un photoamorceur.

2. Résine photoréticulable selon la revendication 1, dans laquelle
- la proportion d'oligomère uréthane photoréticulable (B) est comprise dans une plage allant d'une valeur de 50% en poids à une valeur strictement inférieure à 100% en poids,
- la proportion de la formulation (C) est comprise dans une plage allant d'une valeur strictement supérieure à 0% en poids à une valeur de 50% en poids,
- la proportion de photoamorceur est comprise dans une plage allant de 0,1% en poids à 5% en poids,
de sorte que la résine photoréticulable présente une viscosité inférieure ou égale à 3 Pa.s à 25°C et 100 Hz.

3. Résine photoréticulable selon la revendication 1 ou 2, comprenant en outre un matériau antioxydant dans une proportion allant de 0% en poids à 2% en poids, et/ou un agent azurant dans une proportion allant de 0% en poids à 2% en poids..

4. Résine photoréticulable selon l'une des revendications 1 à 3, dans laquelle l'au moins un polyol fonctionnalisé de la formulation (C) est obtenu par la réaction d'un premier agent de couplage photoréticulable avec au moins un premier polyol.

5. Résine photoréticulable selon l'une des revendications 1 à 4, dans laquelle la formulation (C) comporte un deuxième polyol fonctionnalisé, obtenu par la réaction d'un deuxième agent de couplage photoréticulable avec au moins un deuxième polyol.

6. Résine photoréticulable selon l'une des revendications 1 à 5, dans laquelle l'oligomère d'uréthane photoréticulable (B) est obtenu par réaction entre un oligomère uréthane (A) comprenant des fonctions isocyanates libres et un troisième agent de couplage photoréticulable.

7. Résine photoréticulable selon la revendication 6, dans laquelle le rapport molaire entre les fonctions isocyanates et les groupements réactifs vis-à-vis des isocyanates du troisième agent de couplage est compris dans une plage allant de 1 à 2,5.

8. Résine photoréticulable selon la revendication 6 ou 7, dans laquelle l'oligomère uréthane (A) est obtenu par réaction d'un polyisocyanate, avec au moins un troisième polyol, en présence d'un catalyseur de réaction alcool/isocyanate, le rapport molaire entre les fonctions alcools et les fonctions isocyanates est strictement inférieur à 1 de sorte que la réaction soit incomplète, et que l'oligomère uréthane (A) conserve des fonctions isocyanates libres résiduelles.

9. Résine photoréticulable selon la revendication 8, dans laquelle l'oligomère uréthane (A) est obtenu à partir d'un mélange constitué de polyisocyanate dans une plage allant de 90% en poids à 100% en poids et du troisième polyol dans une plage allant d'une valeur non nulle à une valeur de 10% en poids et de catalyseur dans une plage allant d'une valeur non nulle à une valeur de 0.5% en poids, de sorte à obtenir un oligomère uréthane (A) d'une viscosité inférieure à 10 Pa.s à 25°C sur la gamme 0,1-100Hz.

10. Procédé d'obtention d'une résine de polyuréthane photoréticulé (D), le procédé comprenant les étape de :
- fournir la résine de polyuréthane photoréticulable selon l'une des revendications 1 à 9 et,
- imprimer par stéréolithographie en applicant au moins un rayonnement actinide sur la résine de polyuréthane photoréticulable à sa fréquence de photoréticulation.
